(19) **Europäisches Patentamt European Patent Office Office européen des brevets**

(11) **EP 4 588 715 A1**

(12) **EUROPEAN PATENT APPLICATION**

(43) Date of publication:
**23.07.2025 Bulletin 2025/30**

(21) Application number: **24153022.9**

(22) Date of filing: **22.01.2024**

(51) International Patent Classification (IPC):
**B60L 58/10** (2019.01) **B60L 58/12** (2019.01)
**B60L 58/16** (2019.01)

(52) Cooperative Patent Classification (CPC):
**B60L 58/10; B60L 58/12; B60L 58/16**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Samsung SDI Co., Ltd.**
**Yongin-si, Gyeonggi-do 17084 (KR)**

(72) Inventors:
• **Janek, Alex**
**8041 Graz (AT)**
• **Doczy, Stefan**
**8054 Pirka (AT)**

(74) Representative: **Gulde & Partner**
**Patent- und Rechtsanwaltskanzlei mbB**
**Berliner Freiheit 2**
**10785 Berlin (DE)**

Remarks:
Amended claims in accordance with Rule 137(2) EPC.

(54) **METHOD FOR OPERATING A BATTERY PACK FOR IDENTIFYING AN END-OF-SAFE-OPERATION**

(57) The present disclosure refers to a method for operating a battery pack is provided. Thereby a current intermediate characteristic value characterizing an aging state degree of the battery pack is determined based on detected and/or obtained condition measurement signal. Afterwards, a comparison of the current intermediate characteristic value and a predetermined value of the intermediate characteristic value is performed, wherein the predetermined value includes a value of the intermediate characteristic value at which a sudden cell failure is expected, for identifying an end-of-safe-operation, EoS, of the battery pack. The invention further relates to a battery system including a battery pack, the battery system being configured for performing the disclosed method.

FIG. 2

## Description

### Field of the Disclosure

The present disclosure relates to a method for operating a battery module. The present disclosure also relates to a battery system, the battery system being configured for performing the disclosed method, and an electric vehicle including the battery system.

### Technological Background

Recently, vehicles for transportation of goods and peoples have been developed that use electric power as a source for motion. Such an electric vehicle is an automobile that is propelled permanently or temporarily by an electric motor, using energy stored in rechargeable batteries. An electric vehicle may be solely powered by batteries (Battery Electric Vehicle BEV) or may include a combination of an electric motor and, for example, a conventional combustion engine (Plugin Hybrid Electric Vehicle PHEV). BEVs and PHEVs use high-capacity rechargeable batteries, which are designed to give power for propulsion over sustained periods of time.

Generally, a rechargeable (or secondary) battery cell includes an electrode assembly including a positive electrode, a negative electrode, and a separator interposed between the electrodes. A solid or liquid electrolyte allows movement of ions during charging and discharging of the battery cell. The electrode assembly is located in a casing and electrode terminals, which are positioned on the outside of the casing, establish an electrically conductive connection to the electrodes. The shape of the casing may be, for example, cylindrical, prismatic or rectangular.

A battery module is formed of a plurality of battery cells connected in series or in parallel. That is, the battery module is formed by interconnecting the electrode terminals of the plurality of battery cells depending on a required amount of power and in order to realize a high-power rechargeable battery.

Battery modules can be constructed in either a block design or in a modular design. In the block design each battery cell is coupled to a common current collector structure and a common battery management system and the unit thereof is arranged in a housing. In the modular design, pluralities of battery cells are connected together to form submodules and several submodules are connected together to form the battery module. In automotive applications, battery systems generally include a plurality of battery modules connected in series for providing a desired voltage.

A battery pack is a set of any number of (for example identical) battery modules or single battery cells. The battery modules, respectively battery cells, may be configured in a series, parallel or a mixture of both to deliver the desired voltage, capacity, and/or power density. Components of a battery pack include the individual battery modules, and the interconnects, which provide electrical conductivity between the battery modules.

A battery system may also include a battery management system (BMS), which is any suitable electronic system that is configured to manage the rechargeable battery cell, battery module, and battery pack, such as by protecting the batteries from operating outside their safe operating area, monitoring their states, calculating secondary data, reporting that data, controlling its environment, authenticating it and/or balancing it. For example, the BMS may monitor the state of the battery cell as represented by voltage (e.g., a total voltage of the battery pack or battery modules, and/or voltages of individual battery cells), temperature (e.g., an average temperature of the battery pack or battery modules, coolant intake temperature, coolant output temperature, or temperatures of individual battery cells), coolant flow (e.g., flow rate and/or cooling liquid pressure), and current. Additionally, the BMS may calculate values based on the above parameters, such as minimum and maximum cell voltage, state of charge (SOC) or depth of discharge (DOD) to indicate the charge level of the battery cell, state of health (SOH; a variously-defined measurement of the remaining capacity of the battery cell as % of the original capacity), state of power (SOP; the amount of power available for a defined time interval given the current power usage, temperature and other conditions), state of safety (SOS), maximum charge current as a charge current limit (CCL), maximum discharge current as a discharge current limit (DCL), and internal impedance of a cell (to determine open circuit voltage).

The BMS may be centralized such that a single controller is connected to the battery cells through a multitude of wires. In other examples, the BMS may be also distributed, with a BMS board is installed at each cell, with just a single communication cable between the battery cell and a controller. In yet other examples, the BMS may have a modular construction including a few controllers, each handling a certain number of cells, while communicating between the controllers. Centralized BMSs are most economical, but are least expandable, and are plagued by a multitude of wires. Distributed BMSs are the most expensive, but are simplest to install, and offer the cleanest assembly. Modular BMSs provide a compromise of the features and problems of the other two topologies.

The BMS may protect the battery pack from operating outside its safe operating area. Operation outside the safe operating area may be indicated by over-current, over-voltage (during charging), undervoltage (during discharging), over-temperature, under-temperature, overpressure, and ground fault or leakage current detection. The BMS may prevent the battery from operating outside its safe operating parameter by including an internal switch (e.g., a relay or solid-state device) that opens if the battery is operated outside its safe operating parameters, requesting the devices to which the battery is connected to reduce or even terminate using the battery, and actively controlling the environment, such as through heaters, fans, air conditioning or liquid cooling.

For meeting the dynamic power demands of various electrical consumers connected to the battery system a static control of battery power output and charging is not sufficient. Thus, steady exchange of information between the battery system and the controllers of the electrical consumers is required. This information includes the battery systems actual state of charge, SoC, potential electrical performance, charging ability and internal resistance as well as actual or predicted power demands or surpluses of the consumers. Therefore, battery systems usually include a battery management system, BMS, for obtaining and processing such information on system level and further a plurality of battery module managers, BMMs, which are part of the system's battery modules and obtain and process relevant information on module level. Particularly, the BMS usually measures the system voltage, the system current, the local temperature at different places inside the system housing, and the insulation resistance between live components and the system housing. Additionally, the BMMs usually measure the individual cell voltages and temperatures of the battery cells in a battery module.

Thus, the BMS is provided for managing the battery pack, such as by protecting the battery from operating outside its safe operating area, monitoring its state, calculating secondary data, reporting that data, controlling its environment, authenticating it and/or balancing it.

In case of an abnormal operation state, a battery pack shall usually be disconnected from a load connected to a terminal of the battery pack. Therefore, battery systems further include a battery disconnect unit, BDU, that is electrically connected between the battery module and battery system terminals. Thus, the BDU is the primary interface between the battery pack and the electrical system of the vehicle. The BDU includes electromechanical switches that open or close high current paths between the battery pack and the electrical system. The BDU provides feedback to the battery control unit, BCU, accompanied to the battery modules such as voltage and current measurements. The BCU controls the switches in the BDU using low current paths based on the feedback received from the BDU. The main functions of the BDU may thus include controlling current flow between the battery pack and the electrical system and current sensing. The BDU may further manage additional functions like external charging and pre-charging.

Lithium-ion cells show a critical behavior in the very old aging state, especially with a remaining capacity of less than 50% of the capacity present at the beginning, i.e. the begin of Life, BoL, capacity. Although defined operating limits are followed during aging, sudden failures of the cells occur. Such sudden failures are very difficult to detect because no measurable signal shows any behavior indicating this sudden failure.

Today, applications combine multiple cells in a module and pack design and connect them in series or parallel so that all cells are on the same current path and experience the same load. Sudden cell failures in the combination of packs can result in pack failures that lead to dangerous situations in the application.

To date, further use of the batteries has been prevented only when safety limits are violated or when heavy lithium plating is detected. The likelihood of such limit violations increases with the age of the cell, but there is no guarantee that they will occur. So, there is no guarantee that the battery will remain safe for the time it can be used.

EP 4 026 729 A1 discloses a method for determining an action to be taken based on forecasted End-of-life, EoL, parameters for an electric Energy Storage System, ESS, and for an at least partly electric vehicle in which the electric ESS is comprised. An ESS parameter impacted by utilization of the at least one electric vehicle is obtained and a forecasted EoL ESS parameter is determined based on the at least one ESS parameter. Further, a vehicle parameter impacted by utilization of the at least one electric vehicle is obtained and a forecasted EoL vehicle parameter is determined based on the at least one vehicle parameter. The forecasted EoL ESS parameter and the forecasted EoL vehicle parameter are compared. If the forecasted EoL ESS parameter does not reach the forecasted EoL vehicle parameter or exceeds it, then an action is taken such that the forecasted EoL ESS parameter at least substantially corresponds to the forecasted EoL vehicle parameter.

## Summary of invention

The invention is defined by the appended claims. The description that follows is subjected to this limitation. Any disclosure lying outside the scope of said claims is only intended for illustrative as well as comparative purposes.

According to one aspect of the present disclosure, a method for operating a battery pack is provided, including the steps of a) determining a current intermediate characteristic value characterizing an aging state degree of the battery pack based on detected and/or obtained condition measurement signal; and b) performing a comparison of the current intermediate characteristic value and a predetermined value of the intermediate characteristic value, wherein the predetermined value includes a value of the intermediate characteristic value at which a sudden cell failure is expected.

According to another aspect of the present disclosure, a battery system is provided, including a battery pack including at least one battery cell; a measurement means or a communication interface for detecting and/or obtaining a condition measurement signal; and a control unit; wherein the control unit is configured for performing the following steps of a) determining a current intermediate characteristic value characterizing an aging state degree of the battery pack based on a detected and/or obtained condition measurement signal; and b) performing a comparison of the current intermediate characteristic value and a predetermined value of the intermediate characteristic value, wherein the predetermined value includes a value of the intermediate characteristic value at which a sudden cell failure is expected, for identifying an end-of-safe-operation, EoS, of the battery pack.

Further aspects of the present disclosure could be learned from the dependent claims or the following description.

## Brief Description of the Drawings

Features will become apparent to those of ordinary skill in the art by describing in detail exemplary embodiments with reference to the attached drawings in which:

Fig. 1 illustrates an operation curve of a battery pack and a corresponding capacity aging curve.

Fig. 2 illustrates a method for operating a battery pack according to an embodiment of the invention.

## Detailed Description of the invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art.

Accordingly, processes, elements, and techniques that are not considered necessary to those having ordinary skill in the art for a complete understanding of the aspects and features of the present disclosure may not be described. In the drawings, the relative sizes of elements, layers, and regions may be exaggerated for clarity.

As used herein, the term "and/or" includes any and all combinations of one or more of the associated listed items. Further, the use of "may" when describing embodiments of the present disclosure refers to "one or more embodiments of the present disclosure." In the following description of embodiments of the present disclosure, the terms of a singular form may include plural forms unless the context clearly indicates otherwise.

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present disclosure. Expressions such as "at least one of," when preceding a list of elements, modify the entire list of elements and do not modify the individual elements of the list.

As used herein, the term "substantially," "about," and similar terms are used as terms of approximation and not as terms of degree, and are intended to account for the inherent deviations in measured or calculated values that would be recognized by those of ordinary skill in the art. Further, if the term "substantially" is used in combination with a feature that could be expressed using a numeric value, the term "substantially" denotes a range of +/- 5% of the value centered on the value.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

In the following description of embodiments of the present disclosure, the terms of a singular form may include plural forms unless the context clearly indicates otherwise.

The electronic or electric devices and/or any other relevant devices or components according to embodiments of the present disclosure described herein may be implemented utilizing any suitable hardware, firmware (e.g. an application-specific integrated circuit), software, or a combination of software, firmware, and hardware. Further, the various components of these devices may be implemented on a flexible printed circuit film, a tape carrier package (TCP), a printed circuit board (PCB), or formed on one substrate. The electrical connections or interconnections described herein may be realized by wires or conducting elements, e.g. on a PCB or another kind of circuit carrier. The conducting elements may include metallization, e.g. surface metallizations and/or pins, and/or may include conductive polymers or ceramics. Further electrical energy might be transmitted via wireless connections, e.g. using electromagnetic radiation and/or light.

Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM).

The computer program instructions may also be stored in other non-transitory computer readable media such as, for example, a CD-ROM, flash drive, or the like.

Also, a person of skill in the art should recognize that the functionality of various computing devices may be combined or integrated into a single computing device, or the functionality of a particular computing device may be distributed across one or more other computing devices without departing from the scope of the exemplary embodiments of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

General Concept

According to one aspect of the present disclosure, a method for operating a battery pack is provided. Thereby a current intermediate characteristic value characterizing an aging state degree of the battery pack is determined based on detected and/or obtained condition measurement signal. Afterwards, a comparison of the current intermediate characteristic value and a predetermined value of the intermediate characteristic value is performed, wherein the predetermined value includes a value of the intermediate characteristic value at which a sudden cell failure is expected, for identifying an end-of-safe-operation, EoS, of the battery pack.

Aging tests performed by the inventors under various conditions have shown internal cell defects of cells at a very high age, even though cells of the battery pack were operated under defined operating conditions. These cell defects not only lead to accelerated aging, as evidenced by a drop in a capacity aging curve, but also increase the likelihood that the cell will suddenly fail without warning. A capacity aging curve may be measured by frequent reference tests doing a full charge and full discharge to measure the cell capacity. Such a situation can lead to potentially dangerous situations when these cells are operated in an application. The aforementioned internal cell defects cannot be measured directly by measurement signals available in the application, such as voltage, current or temperature. This is usually only possible by indirect calculation of the capacity and resistance rise, which is not possible in operation with the available measurement signal accuracy in the required safety quality.

Detection of the risk for the described cell defects in an aged cell can only be done in safety quality by measuring both capacity and resistance in a laboratory environment. By the invention, an intermediate characteristic value is used. This can be measured both in operation and under laboratory conditions with a very high precision and therefore provides the required safety quality.

This intermediate characteristic value refers to and characterizes an aging state degree of the battery pack, so that a knowledge of the aging state of the battery pack is available.

The aging state degree refers to the battery pack. This may include the capacity, i.e. the amount of energy stored in the battery pack. Accordingly, the current intermediate characteristic value refers to a current aging state degree, whereas the predetermined value of the intermediate characteristic value refers to a predetermined aging state degree.

The predetermined value includes a value of the intermediate characteristic value at which a sudden cell failure is expected. In other words, the predetermined value refers to an end-of-safe-operation, EoS. In other words, it may be an age to be defined at which a cell failure is expected with a probability that may also to be predetermined. According to an embodiment, this is a percentage value of the capacity of a new battery pack that initially has a capacity of 100%. For example, the predetermined value refers to a value of 70% to 50%, 60% to 50% and 55% to 50% of the original capacity of the battery pack. Additionally or alternatively, the intermediate characteristic value at which a sudden cell failure is expected is defined based on experimentally determined probabilities for a cell failure. According to an embodiment, the probability of cell failure includes 20 - 70%, 30 - 60%, and 35 - 45%. In other words, the value of the intermediate characteristic value is thus defined as the predetermined value of the intermediate characteristic value at which a cell failure is expected with one of the stated probabilities.

According to an embodiment, the aging stage degree is characterized by the respective aging stage degree of battery modules and/or individual cells of the battery pack and, for example, by the most advanced aging stage of a battery module and/or a cell, if this differs from battery module to battery module and/or cell to cell. Thus, the intermediate characteristic value may be at least determined for the smallest unit of the battery pack that is replaceable. This therefore depends on the structure of the battery pack. The smallest unit is often a battery module. Accordingly, the end-of-safe-operation may also be described by this unit. For example, the battery pack includes several battery modules, of which only one has reached its end-of-safe-operation, but the others have not. Thus, this one battery module could be replaced and the battery pack can continue to be operated.

By comparing the current intermediate characteristic value and the predetermined value of the intermediate characteristic value, both of which characterize an aging state degree, it is possible to make statements about reaching the end-of-safe-operation due to cell aging-related internal cell defects and thus increased probability of sudden cell failure.

According to an embodiment, the comparison includes a determination of whether the current intermediate characteristic value has reached and/or exceeded the predetermined value of the characteristic intermediate value.

The invention provides a way to ensure the safety of battery packs - even in old age - by measuring an intermediate characteristic during operation and comparing it to a threshold value, the predetermined value of the intermediate characteristic value.

According to one embodiment the method further includes outputting a warning message and/or locking the battery back when the end-of-safe-operation of the battery pack is identified. The occurrence of sudden cell failures can lead to safety-relevant situations. In this respect, information is provided in the form of a warning, which prompts a user to take further action and enables appropriate intervention at the right time. By locking the battery pack, action is taken immediately and the risk of consequential damage due to continued operation and a resulting failure is significantly reduced. In other words, the battery pack is locked when cells of the battery pack have reached a level of usage at which it is no longer ensured that the battery pack can be operated safely.

According to another embodiment, the method further includes determining a deviation between the current intermediate characteristic value and the predetermined value of the intermediate characteristic value. This enables one for identifying the end-of-safe-operation of the battery pack based on a result of the determined deviation.

In an embodiment, the method further includes performing a comparison of the determined deviation to a first threshold value. For example, the first threshold value is an absolute and/or a relative threshold value. In case of an absolute threshold value, consequently a distance between the current intermediate characteristic value and the predetermined value of the intermediate characteristic value is monitored in the form of the deviation and this distance is compared with the first threshold value. In case of a relative threshold value the threshold value may be a percentage value representing a percentage deviation defined by the user and deemed permissible. This means that an absolute distance adapted to an application or the battery pack does not have to be defined each time. Instead, a deviation can be defined in the form of a percentage. In this case, the predetermined value of the intermediate characteristic value defines the 100% and, based on this, the percentage deviation between the current intermediate characteristic value and the predetermined value of the intermediate characteristic value is calculated and compared with a predetermined percentage limit value.

In a further embodiment, the method further includes determining the end-of-safe-operation of the battery pack when the deviation falls below the first threshold value. Since the current intermediate characteristic value characterizes the aging state degree, which is constantly increasing, the current intermediate characteristic value is also constantly increasing. Accordingly, a distance between the current intermediate characteristic value and the predetermined value of the intermediate characteristic value decreases. The first threshold value defines a distance between the two values which is tolerable, for example. Due to aging, however, this distance is undershot at a certain point and the current intermediate characteristic value approaches the predetermined value of the intermediate characteristic value. Consequently, the deviation falls below the first threshold value at a certain aging point. Based on this point, it is now possible to reliably and accurately detect the end-of-safe-operation of the battery pack and safe operation is enabled.

In a further embodiment of the present disclosure, the method further includes steps of performing a comparison of the deviation to the first threshold value and a second threshold value, outputting a warning message if the deviation falls below the first threshold value and locking the battery pack if the deviation falls below the first threshold value and the second threshold value. Accordingly, it is first determined whether the aging state degree of the battery pack is approaching the safety-relevant range by marking this range with the first threshold value. A user, for example, is informed of this and can take action if necessary or arrange for more attentive monitoring of the battery pack in question. In addition, the battery pack is locked if it also falls below the second threshold value, preventing critical operation of the battery pack. This implements a multi-level safety system and provides detailed information about several levels of critical areas of the battery pack.

According to another embodiment, the intermediate characteristic value includes an energy throughput, ETP. The ETP can be measured with a very high precision both in operation and under laboratory conditions and therefore provides a required safety quality and thus represents a particularly suitable intermediate characteristic value characterizing the aging condition.

According to an embodiment, the detected and/or obtained condition measurement signal includes a voltage, a current, and/or an elapsed time of the battery system. Voltage u and current i may be monitored at a module level, but can also be monitored at the pack or a cell level. The intermediate characteristic is not limited to ETP. However, voltage, current, and/or elapsed time t are monitored, as the intermediate characteristic is usually positively correlated with these and can therefore be determined from the condition measurement signal. Usually the cells are connected in series and cells connected in parallel are hard-connected to form a virtual large cell (logical cell). This means that practically only the voltage of the individual logical cells is monitored and the current applies to all logical cells. In the parallel connection of the physical cells to the logical cell it is assumed that the current is divided symmetrically i.e. that each physical (single) cell sees the same current. Therefore, the current through the physical cell is not measured. In case of a battery module as smallest unit of the battery pack, for example, the voltage resulting from single battery cells of a battery module of the battery pack is used. This is then used to determine for example the ETP of the battery module of the battery pack. Often the battery modules of the battery pack are connected in series so that the current through them is the same. The total ETP is then determined for each module of the battery pack. This enables one, to lock the battery pack and change the smallest unit that is replaceable, whose end-of-safe-operation is identified.

Further, the elapsed time may be measured independently of the current. For example, if the battery pack is not used, no current flows at all, so that an intermediate characteristic value such as ETP would not increase, but the cells would still age due to the pure elapsed time. This is considered by this design, so that an even more precise picture of the aging state degree of the battery pack is available.

According to another embodiment, the ETP is determined by

$$ETP = \int_0^t u * i \, dt.$$

With this rule, based on the condition measurement signal, the ETP can be precisely determined by the accumulation of the ETP in each unit of time. Here u represents the time-dependent voltage and i the time-dependent current provided by the battery pack. In case of a battery module as smallest unit of the battery pack, the voltage u and current i provided by single battery cells of a battery module of the battery pack are used alternatively. When applying the above formula, it should be noted that there are various known methods for determining the result based on the above rule. A simple example to illustrate this is the combination of calculating the mean value of the aforementioned variables within a time interval delta t and the trapezoidal rule when measuring at discrete points in time. The arithmetic mean of the value is determined using the measured values $u_{i-1}$ and $u_i$ or $i_{i-1}$ and $i_i$ at the time points $t_{i-1}$ and $t_i$ and the integral is then calculated by multiplying by the time interval delta t. This is carried out for all measured values and thus the integral is calculated approximately. In other words, the above formula represents the exact calculation rule, which is then applied to the practical application using known mathematical methods.

The condition measurement signal may be measured during a charging operation and discharging operation. The battery pack also ages to a certain extent during these processes. By taking this into account, the reliability of a statement on the aging state degree based on the method according to the invention increases.

According to a further embodiment, the first and/or second predetermined value of the intermediate characteristic value is predetermined in a laboratory environment based on a same type of battery cell that is used in the battery pack. For the use of the first and/or second predetermined value of the intermediate characteristic value as part of the aging benchmark, the corresponding limit value for the corresponding value of the intermediate characteristic value must be defined. According to this embodiment, this definition is done by aging cells in test laboratories under different reference conditions and under compliance with defined operational limits, for example, until a point in time when previously defined values of a battery are undercut due to aging. For example, until an EoL and/or a knee effect is observed and/or until cell failures occur more frequently, so that this point characterizes an increased probability of cell failure. During this aging process, the intermediate characteristic value, for example the ETP, is accumulated. The intermediate characteristic value until the said characteristic points are reached under reference conditions is used to define the value of the intermediate characteristic value at which a predefined value of the aging state degree is undercut and/or the EoS is reached and thus the first and/or second predetermined value of the intermediate characteristic value is determined. The first and/or second predetermined value of the intermediate characteristic value is used in operation to estimate the remaining usage time of the cell and for example, to lock the battery pack to prevent further usage, when EoS is reached. The knee effect describes accelerated capacity aging and signals that cell aging-related internal cell defects increase the probability of sudden cell failure. According to an embodiment, a cell test continues even after the knee effect has occurred to monitor behavior after the knee effect has set in. This provides some assurance that the cell can still be operated once the knee effect has set in. This allows for tolerance ranges to be considered, for example in conjunction with use of first and second threshold values. The first and/or second predetermined value of the intermediate characteristic value may include a value of a characteristic curve, for example, a capacity curve of the battery pack, at which a certain capacity of the battery pack is undercut and/or a knee effect of a battery cell starts.

In a further embodiment of the present disclosure, the second predetermined value of the intermediate characteristic value includes a value of the intermediate characteristic value at which a vent valve of a respective battery cell of the battery pack opens. In other words, this represents a point at which a cell of the battery pack begins to degas, thereby also providing a suitable characteristic by which a critical region is defined in terms of the EoS.

According to a further embodiment, the first and/or second predetermined value of the intermediate characteristic value is adjusted during operation of the battery pack depending on the usage of the specific battery pack, an aging feedback from a field with a plurality of battery packs of the same type of battery pack, and/or an application of the battery pack. In other words, consideration is given to whether, for example, harsh or mild conditions exist that cause premature onset of knee effect or earlier than originally predicted cell failures, or conversely, delayed onset of knee effect or later than originally predicted cell failures. This adjusts the first and/or second predetermined value of the intermediate characteristic value by considering the operating conditions so that an adjusted procedure is performed. The same applies to specific applications of the battery pack to reflect requirements and benefits of changing and different applications, for example, first-life applications, second-life applications, and third-life applications.

A second aspect of the present disclosure relates to a battery system including a battery pack including at least one battery cell, a measurement means or a communication interface for detecting and/or obtaining a condition measurement signal, and a control unit. The control unit is configured for performing the following steps of determining a current intermediate characteristic value characterizing an aging state degree of the battery pack based on a detected and/or obtained condition measurement signal, and performing a comparison of the current intermediate characteristic value and a predetermined value of the intermediate characteristic value, wherein the predetermined value includes a value of the intermediate characteristic value at which a sudden cell failure is expected, for identifying an end-of-safe-operation, EoS, of the battery pack.

A third aspect of the present disclosure relates to an electric vehicle including the battery system according to the invention.

Specific Embodiments

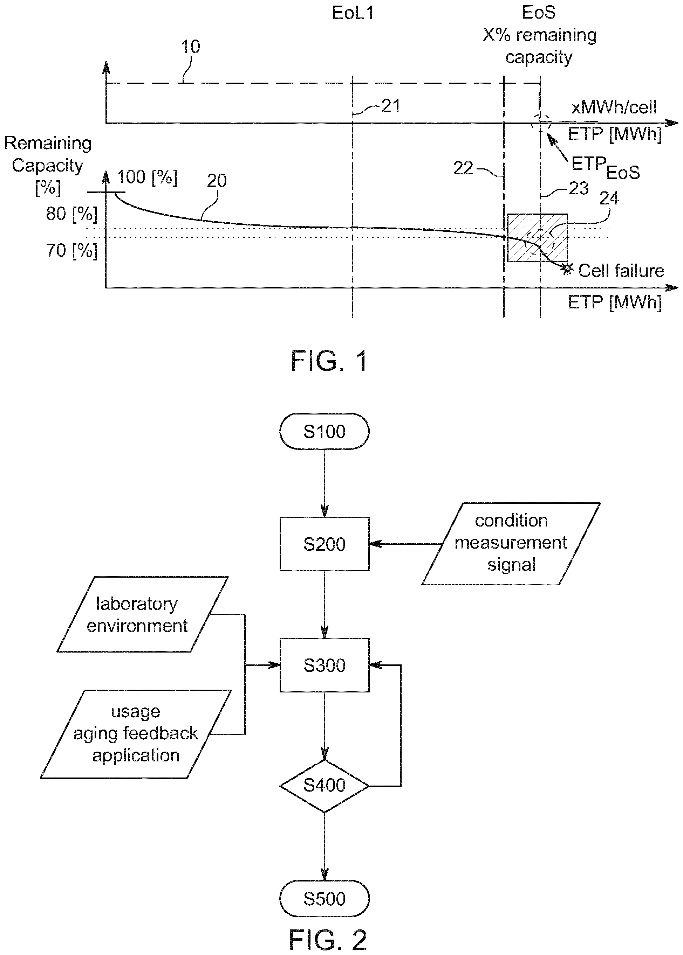

The upper part of Fig. 1 illustrates the course of an exemplary operation curve of a battery pack 10. In this example, the battery pack is operated at a constant rate, as shown by the curve 10 plotted against the ETP. For illustration purposes, a binary representation is shown to show whether the battery pack 10 is switched on or not. If the line goes to 0, the battery pack 10 is permanently switched off, if the line goes to 1, the pack is allowed to be switched on. The lower part of Fig. 1 shows a capacity aging curve of the battery pack 20 corresponding to the operation curve 10. Here, the capacity is the amount of energy that can be stored in the battery pack. At the beginning of its initial operation, begin of life, BoL, it is assumed that the capacity of the battery pack is 100%. During operation, the battery pack provides energy for applications or absorbs energy in the case of a charging process. Both mechanisms result in aging of cells of the battery pack. The capacity of the battery pack - i.e. the amount of energy that can be extracted - decreases in the course of use. In the case of lithium-ion batteries, it even decreases in part over time without being used, which is referred to as the calendar life. This is also represented by the corresponding capacity aging curve 20. At the beginning, the capacity decreases with an initially steep negative slope, with the amount of the slope decreasing during progressive operation.

A dashed vertical line furthest to the left indicates a point at which previously defined values are undershot by aging, also known as first end-of-life, EoL1, 21. The end-of-life does not necessarily mean that a battery no longer functions. It is only usual to define parameters for a battery pack that must not be exceeded or fallen short of. In the present case, the parameter is a capacity, which is specified here as 80% for the first end-of-life 21. Furthermore, a second end-of-life 22 is shown, for which a capacity of 70% is assumed. Battery packs, especially lithium ion cells, have shown critical behavior in very old aging state, in particular with a remaining capacity of less than 50% of the begin of life capacity. Although defined operational limits have been considered during aging, sudden failures of the cells can occur. Such sudden failures are very hard to detect, because no measurable signal is showing a behavior which is indicating this sudden failure.

In the further course, a region of the corresponding capacity aging curve 20 is recognizable, which is characterized by significantly larger negative slopes of the curve. This is where a so-called knee effect 24 occurs, indicated by a dashed vertical line furthest to the right. The knee effect 24 describes an accelerated capacity aging and signals that the cell aging-related internal cell defects increase the probability of a sudden cell failure. According to the invention, this range is used to define a time at which a sudden cell failure is expected, for identifying an end-of-safe-operation, EoS, 23 of the battery pack.

In the present case, Fig. 1 also illustrates the course observed during a laboratory test, which is used to determine a predetermined value of the intermediate characteristic value used within the method according to the invention. In other words, the predetermined value of the intermediate characteristic value is predetermined in a laboratory environment based on using a same type of battery cell that is used in the battery pack.

Thus, an intermediate characteristic value such as the energy throughput, ETP, in the present embodiment is required for this purpose. The ETP can be measured with a very high precision both in operation and under laboratory conditions and therefore provides the required safety quality. This process is also described by Fig. 1.

For the use of ETP as an aging benchmark, a corresponding limit value of ETP for EoS 23, hereinafter referred to as $ETP_{EoS}$, must be defined. This then represents the predetermined value of the intermediate characteristic value. This definition is done by aging cells in a test laboratory under different reference conditions and respecting defined operating limits until the knee effect is observed. The cell test itself is continued to monitor behavior after the knee effect has set in. This provides some assurance that the cell can still be operated once the knee effect has set in.

During this aging process, the ETP is accumulated. The ETP until the knee effect 24 is reached under reference conditions is then used to define the EoS 23. This $ETP_{EoS}$ is then used in the method of the invention as the predetermined value of the intermediate characteristic value and to estimate the remaining time of use of the cell and to lock the battery pack to prevent further use.

Fig. 2 illustrates a method for operating a battery pack according to an embodiment of the invention. In a first step S100 the operating of the battery pack starts.

Subsequently, in step S200 a current intermediate characteristic value is determined. The ETP can be measured with a very high precision both in operation and under laboratory conditions and therefore provides a required safety quality and thus represents a particularly suitable intermediate characteristic value characterizing the aging condition. According to the present embodiment, a detected and/or obtained condition measurement signal includes a voltage u, a current i, and an elapsed time t of the battery system. Voltage u and current i may be monitored at a module level, but can also be monitored at the pack or a cell level. Voltage u, current i, and/or elapsed time t are monitored as the intermediate characteristic and are usually positively correlated with these and can therefore be determined from the condition measurement signal. The ETP is determined by

$$ETP = \int_0^t u * i \, dt.$$

Then in step S300 the current intermediate characteristic value ETP and a predetermined value of the intermediate characteristic value are compared with each other. The predetermined value of the intermediate characteristic value is in this case the $ETP_{EoS}$, which was explained in the context of Fig. 1 and whose determination was described under a laboratory environment. According to an embodiment, a deviation between the current intermediate characteristic value and the predetermined value of the intermediate characteristic value is determined by difference formation. This can then be present as an absolute difference and used in the further procedure or in the form of a relative deviation with respect to the $ETP_{EoS}$.

In step S400 the comparison condition is checked. It is conceivable that the current intermediate characteristic value has an ETP that corresponds to the ETP at the first end-of-life 21. This means that no cell failure is to be expected and further operation of the battery pack is possible. This comparison may be made by comparing the current intermediate characteristic value with an $ETP_{EoL}$ determined during the laboratory test at the time of the first EoL 21. Even if the current intermediate characteristic value exceeds the $ETP_{EoL}$, continued operation can occur. Accordingly, steps S300 and S400 are repeated in this scenario.

In another scenario, an ETP is now determined for the current intermediate characteristic value that exceeds the $ETP_{EoS}$. This means that the battery pack has reached the point in time or the age at which there is an increased probability of cell failure. Therefore, to avoid a problematic situation, the comparison condition in step S400 is used to determine that the current intermediate characteristic value exceeds the $ETP_{EoS}$ and the battery pack is disabled.

According to an embodiment, the predetermined value of the intermediate characteristic value $ETP_{EoS}$ is adjusted during operation. Accordingly, the limit value $ETP_{EoS}$ is adjusted during the life of the battery pack to account for aging feedback from a field and to reflect requirements and benefits of changing and different applications. These include, for example, first-life application, second-life application, third-life application, extra mild application, extra harsh application, restricted temperature range application, and the like. In other words, the $ETP_{EoS}$ is redefined or updated on an ongoing basis, for example, depending on the requirements of different applications.

## Reference signs

| | |
|---|---|
| 10 | operation curve of a battery pack |
| 20 | capacity aging curve of a battery pack |
| 21 | first end-of-life, EoL1 |
| 22 | second end-of-life, EoL2 |
| 23 | end-of-safe-operation, EoS |
| 24 | knee effect |
| $ETP_{EoS}$ | ETP at end-of-safe-operation, EoS, |
| S100 | operating a battery pack |
| S200 | determining a current intermediate characteristic value |
| S300 | performing a comparison of the current intermediate characteristic value and a predetermined value of the intermediate characteristic value |
| S400 | comparison condition |
| S500 | locking the battery back |

## Claims

1. A method for operating a battery pack, including the steps of:

   a) Determining a current intermediate characteristic value characterizing an aging state degree of the battery pack based on a detected and/or obtained condition measurement signal; and
   b) Performing a comparison of the current intermediate characteristic value and a predetermined value of the intermediate characteristic value, wherein the predetermined value includes a value of the intermediate characteristic value at which a sudden cell failure is expected, for identifying an end-of-safe-operation, EoS, of the battery pack.

2. Method according to claim 1, wherein the method further includes the step of:
Outputting a warning message and/or locking the battery back when the end-of-safe-operation of the battery pack is identified.

3. Method according to any one of the preceding claims, wherein the comparison further includes:
Determining a deviation between the current intermediate characteristic value and the predetermined value of the intermediate characteristic value.

4. Method according to claim 3, wherein the method further includes:
Performing a comparison of the determined deviation to a first threshold value.

5. Method of claim 4, wherein the method further includes:
Determining the end-of-safe-operation of the battery pack when the deviation falls below the first threshold value.

6. Method of claim 4, wherein the method further includes:

   Performing a comparison of the deviation to the first threshold and a second threshold;
   Outputting a warning message if the deviation falls below the first threshold; and
   Locking the battery pack if the deviation falls below the first threshold and the second threshold.

7. Method according to any one of the preceding claims, wherein the intermediate characteristic value includes an energy throughput, ETP.

8. Method according to any one of the preceding claims, wherein the detected and/or obtained condition measurement signal includes a voltage, a current, and/or an elapsed time of the battery system.

9. Method according to claim 8, wherein the elapsed time is measured independently of the current.

10. Method according to claims 7 and 8 or 9, wherein the ETP is determined by

$$ETP = \int_0^t u * i \, dt.$$

11. Method according to any one of the preceding claims, wherein the condition measurement signal is measured during a charging operation and/or discharging operation.

12. Method according to any one of the preceding claims, wherein the predetermined value of the intermediate characteristic value is predetermined in a laboratory environment based on a same type of battery cell that is used in the battery pack.

13. Method according to any one of the preceding claims, wherein the predetermined value of the intermediate characteristic value includes a value of the intermediate characteristic value at which a vent valve of a respective battery cell of the battery pack opens.

14. Method according to any one of the preceding claims, wherein the predetermined value of the intermediate characteristic value is adjusted during operation of the battery pack depending on:

   a usage of the specific battery pack,
   an aging feedback from a field with a plurality of battery packs of the same type of battery pack, and/or
   an application of the battery pack.

15. A battery system, including:

   a battery pack including at least one battery cell;
   a measurement means or a communication interface for detecting and/or obtaining a condition measurement signal; and
   a control unit;
   wherein the control unit is configured for performing the following steps of:

   a) Determining a current intermediate characteristic value characterizing an aging state degree of the battery pack based on a detected and/or obtained condition measurement signal; and
   b) Performing a comparison of the current intermediate characteristic value and a predetermined value of the intermediate characteristic value, wherein the predetermined value includes a value of the intermediate characteristic value at which a sudden cell failure is expected, for identifying an end-of-safe-operation, EoS, of the battery pack.

**Amended claims in accordance with Rule 137(2) EPC.**

1. A method for operating (S100) a battery pack, including the steps of:

a) Determining (S200) a current intermediate characteristic value characterizing an aging state degree (20) of the battery pack based on a detected and/or obtained condition measurement signal; and
b) Performing a comparison (S300) of the current intermediate characteristic value and a predetermined value of the intermediate characteristic value, wherein the predetermined value includes a value of the intermediate characteristic value at which a sudden cell failure is expected, for identifying an end-of-safe-operation, EoS, of the battery pack;

wherein the intermediate characteristic value includes an energy throughput, ETP.

2. Method according to claim 1, wherein the method further includes the step of:
Outputting a warning message and/or locking the battery back when the end-of-safe-operation of the battery pack is identified.

3. Method according to any one of the preceding claims, wherein the comparison further includes:
Determining a deviation between the current intermediate characteristic value and the predetermined value of the intermediate characteristic value.

4. Method according to claim 3, wherein the method further includes:
Performing a comparison of the determined deviation to a first threshold value.

5. Method of claim 4, wherein the method further includes:
Determining the end-of-safe-operation of the battery pack when the deviation falls below the first threshold value.

6. Method of claim 4, wherein the method further includes:

Performing a comparison of the deviation to the first threshold and a second threshold;
Outputting a warning message if the deviation falls below the first threshold; and
Locking the battery pack if the deviation falls below the first threshold and the second threshold.

7. Method according to any one of the preceding claims, wherein the detected and/or obtained condition measurement signal includes a voltage, a current, and/or an elapsed time of the battery system.

8. Method according to claim 7, wherein the elapsed time is measured independently of the current.

9. Method according to claim 7 or 8, wherein the ETP is determined by $ETP = \int_0^t u * i \, dt$.

10. Method according to any one of the preceding claims, wherein the condition measurement signal is measured during a charging operation and/or discharging operation.

11. Method according to any one of the preceding claims, wherein the predetermined value of the intermediate characteristic value is predetermined in a laboratory environment based on a same type of battery cell that is used in the battery pack.

12. Method according to any one of the preceding claims, wherein the predetermined value of the intermediate characteristic value includes a value of the intermediate characteristic value at which a vent valve of a respective battery cell of the battery pack opens.

13. Method according to any one of the preceding claims, wherein the predetermined value of the intermediate characteristic value is adjusted during operation of the battery pack depending on:

a usage of the specific battery pack,
an aging feedback from a field with a plurality of battery packs of the same type of battery pack, and/or
an application of the battery pack.

14. A battery system, including:

a battery pack including at least one battery cell;
a measurement means or a communication interface for detecting and/or obtaining a condition measurement signal; and
a control unit;
wherein the control unit is configured for performing the following steps of:

a) Determining a current intermediate characteristic value characterizing an aging state degree of the battery pack based on a detected and/or obtained condition measurement signal; and
b) Performing a comparison of the current intermediate characteristic value and a predetermined value of the intermediate characteristic value, wherein the predetermined value includes a value of the intermediate characteristic value at which a sudden cell failure is expected, for identifying an end-of-safe-operation, EoS, of the battery pack

wherein the intermediate characteristic value includes an energy throughput, ETP.

FIG. 1

FIG. 2

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2022/136967 A1 (SES HOLDINGS PTE LTD [SG]) 30 June 2022 (2022-06-30) | 1-8, 11-13,15 | INV. B60L58/10 |
| Y | * paragraphs [0002], [0032], [0038], [0044], [0072], [0074], [0079], [0082] * <br> * figures 5, 9, 10 * <br> - - - - - | 9,10,14 | B60L58/12 B60L58/16 |
| Y | US 10 196 053 B2 (RENAULT SAS [FR]) 5 February 2019 (2019-02-05) <br> * column 4, line 52 - line 57 * <br> * claim 1 * <br> - - - - - | 9,10 | |
| Y | US 2019/176639 A1 (KUMAR PANKAJ [US] ET AL) 13 June 2019 (2019-06-13) <br> * paragraph [0117] - paragraph [0120] * <br> * figures 5, 7 * <br> - - - - - | 14 | |

TECHNICAL FIELDS
SEARCHED      (IPC)

B60L

The present search report has been drawn up for all claims

| Place of search | Date of completion of the search | Examiner |
|---|---|---|
| The Hague | 18 June 2024 | Lutz, Tobias |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 15 3022

This annex lists the patent family members relating to the patent documents cited in the above-mentioned European search report.
The members are as contained in the European Patent Office EDP file on
The European Patent Office is in no way liable for these particulars which are merely given for the purpose of information.

18-06-2024

| Patent document cited in search report | Publication date | Patent family member(s) | Publication date |
|---|---|---|---|
| WO 2022136967 A1 | 30-06-2022 | CN 116670886 A | 29-08-2023 |
| | | EP 4268348 A1 | 01-11-2023 |
| | | KR 20230124620 A | 25-08-2023 |
| | | US 2024097460 A1 | 21-03-2024 |
| | | WO 2022136967 A1 | 30-06-2022 |
| US 10196053 B2 | 05-02-2019 | CN 107207004 A | 26-09-2017 |
| | | EP 3237258 A1 | 01-11-2017 |
| | | FR 3030768 A1 | 24-06-2016 |
| | | JP 6650465 B2 | 19-02-2020 |
| | | JP 2018504322 A | 15-02-2018 |
| | | KR 20170096024 A | 23-08-2017 |
| | | US 2017369048 A1 | 28-12-2017 |
| | | WO 2016102856 A1 | 30-06-2016 |
| US 2019176639 A1 | 13-06-2019 | CN 109901075 A | 18-06-2019 |
| | | DE 102018131626 A1 | 13-06-2019 |
| | | US 2019176639 A1 | 13-06-2019 |

EPO FORM P0459

For more details about this annex : see Official Journal of the European Patent Office, No. 12/82

**EP 4 588 715 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 4026729 A1